# EUROPÄISCHE PATENTANMELDUNG

(11) **EP 4 080 564 A1**
(43) Veröffentlichungstag der Anmeldung: **26.10.2022**
(21) Anmeldenummer: 21169988.9
(22) Anmeldetag: 22.04.2021
(51) Int. Cl.: H01L 23/488, H01L 21/60

(54) **ELEKTRISCHER KONTAKT EINES AUF EINEN SCHALTUNGSTRÄGER AUFBRINGBAREN SCHALTUNGSELEMENTS ODER EINES ELEKTRISCHEN VERBINDERS SOWIE VERFAHREN ZUM HERSTELLEN EINER ELEKTRISCH LEITENDEN VERBINDUNG**

(71) Anmelder: Siemens Aktiengesellschaft, 80333 München (DE)
(72) Erfinder: Feil, Wolfgang, 92421 Schwandorf (DE); Kiefl, Stefan, 80992 München (DE); Schaller, Karl-Heinz, 92289 Ursensollen (DE); Stegmeier, Stefan, 81825 München (DE); Wöllmer, Heinz, 92260 Ammerthal (DE)

(57) **Zusammenfassung**

Die vorliegende Erfindung betrifft elektrische Kontakte und ein Verfahren zum Herstellen einer elektrischen Verbindung zwischen diesen Kontakten. Ein erster elektrischer Kontakt (10) weist einen flächigen Abschnitt auf, auf dem mindestens ein Zapfen (11) ausgebildet ist, der zum Einbringen in einen ein poröses oder schaumartiges leitfähiges Material aufweisenden Bereich (21) des zweiten Kontakts (20) ausgebildet ist. Die elektrische Verbindung entsteht durch Einbringen der Zapfen (11) in den weichen Bereich (21), wobei dabei eine zumindest teilweise Verdrängung des porösen oder schaumartigen leitfähigen Materials (21) durch den Zapfen (11) stattfindet.

## Beschreibung

Die vorliegende Erfindung betrifft eine neuartige Aufbau- und Verbindungstechnik, insbesondere für die Leistungselektronik.

Die Aufbau- und Verbindungstechnik hat die Aufgabe, elektrische und mechanische Verbindungen zwischen den einzelnen Elementen einer Schaltung und ggf. einem Schaltungsträger zu schaffen.

Insbesondere für Leistungshalbleiter hat es sich als vorteilhaft herausgestellt, diese mit Kontakten oder Kontaktflächen an mehreren Seiten auszustatten, also beispielsweise leiterplattenseitigen Kontakten und oberseitigen Kontakten. Verschiedene Aufbau- und Verbindungstechniken sind bekannt und in der Publikation "Applikationshandbuch Leistungshalbleiter", Herausgeber Semikron International GmbH, 2. Auflage 2015, ISBN 978-3-938843-85-7, in Kapitel 2.5 ausführlich beschrieben.

Das dort beschriebene Drahtbonden an der Oberseite hat allerdings den Nachteil, dass während der Herstellung der Verbindung Kräfte aufgewendet werden, durch welche das Halbleiterbauelement beschädigt werden können. Zudem können im Betrieb lokale Temperaturerhöhungen entstehen, denen durch die Verwendung von mehreren Bonddrähten und dem sogenannten Stitching nur bedingt entgegengewirkt werden kann. Die Kontaktierungspunkte sind unvermeidbar einer punktuellen thermischen Belastung ausgesetzt und auch die Bonddrähte erwärmen sich aufgrund des während des Betriebs durch sie fließenden Stroms und ihres durch das Bondverfahren begrenzten Querschnitts. Ferner können aufgrund von Induktion in den Bonddrähten unerwünschte elektrische Störsignale in die Schaltung eingebracht werden, insbesondere kann bei parallel verlaufenden Bonddrähten, die zu verschiedenen Kontakten führen, ein unerwünschtes Übersprechen auftreten.

Als Alternative zu Bonddrähten sind u.a. aus vorstehend genannter Publikation Sinterverfahren bekannt, die im Gegensatz zu den Bonddrähten flächige Verbindungen mit deutlich größeren Querschnitten erlauben und sowohl trägerseitig als auch oberseitig einsetzbar sind und sich gegenüber Lötverbindungen durch eine deutlich höhere Temperaturbeständigkeit auszeichnen. Nachteilig an diesen Sinterverfahren ist jedoch der hohe Fertigungsaufwand bei Bestückung der Leiterplatten bzw. Schaltungsträger und insbesondere der hohe Druck, der für den Sintervorgang erforderlich ist.

Schließlich sind u.a. ebenfalls aus der vorstehend genannten Publikation Druckkontaktierungen bekannt, die an die Stelle der vorgenannten stoffschlüssigen Verbindungsarten treten. Dabei gleiten die verbundenen Partner aufeinander und vermeiden damit thermische Spannungen, die bei den stoffschlüssigen Verbindungen im Betrieb zwangsläufig auftreten und z.B. mittels geeignet flexibler Materialien kompensiert werden müssen. Druckkontaktierungen haben allerdings den Nachteil, dass auf den Halbleiter dauerhaft Druck ausgeübt wird, der sich mit der Temperatur ändert und das Halbleiterbauelement im Laufe der Zeit beschädigen kann. Zudem erfordern flächige Kontaktierungen perfekt ebene Flächen und es muss sichergestellt werden, dass die aufeinander gleitenden Kontakte dauerhaft frei von Verschmutzungen und Oxidschichten bleiben.

Aus der WO 2021/013401 A1 sind formschlüssige Verbindungen zwischen einer Entwärmungskörperanordnung und einem Leistungshalbleiter bekannt, die durch eine Vielzahl stelenartiger Entwärmungskörper und dazu korrespondierenden Kavitäten gebildet werden, um die Oberfläche der Kontaktierung zu erhöhen und die Nachteile der Druckkontaktierungen zu vermeiden, indem nach erfolgter Montage keine Kräfte mehr auf die Oberfläche des Halbleiters wirken. Allerdings erfordert die Montage der Entwärmungskörperanordnung einen zusätzlichen Arbeitsschritt, nämlich das Verkleben oder Verlöten der Verbindung.

Eine Aufgabe der vorliegenden Erfindung ist es, eine weiter verbesserte Aufbau- und Verbindungstechnik anzugeben.

Diese Aufgabe wird durch besonders geformte elektrische Kontakte eines auf einen Schaltungsträger aufbringbaren Schaltungselements sowie des dazu passenden elektrischen Verbinders gelöst. Erfindungsgemäß weist einer der Kontakte einen flächigen Abschnitt auf, auf dem ein Zapfen ausgebildet ist, und der Partnerkontakt weist einen Bereich mit einem porösen oder schaumartigen leitfähigen Material auf, in welches der Zapfen eingebracht werden kann. Im gefügten Zustand bildet der Zapfen mit dem Bereich eine elektrisch leitende Verbindung.

Die vorliegende Erfindung betrifft ferner ein Verfahren zum Herstellen einer elektrisch leitenden Verbindung zwischen einem auf einem Schaltungsträger anbringbaren Schaltungselement und einem weiteren Element, die über Kontakte wie vorstehend beschrieben verfügen. Zur Herstellung der elektrisch leitenden Verbindung wird der Zapfens in den Bereich dem porösen oder schaumartigen leitfähigen Material eingebracht und dabei erfolgt eine teilweises Verdrängung des porösen oder schaumartigen leitfähigen Materials durch den Zapfen und somit wird eine elektrisch leitfähige Verbindung bewirkt.

Die erfindungsgemäße Aufbau- und Verbindungstechnik hat dabei den wichtigen Vorteil, dass zuverlässige und dauerhafte elektrische und mechanische Verbindungen geschaffen werden können, und zwar in vielen Fällen ohne Erhitzen der Verbindungsstelle. Halbleiter können also bei Raumtemperatur angebunden werden und es können damit z.B. auch innerhalb polymerbasierter Gehäuse Verbindungen hergestellt werden, ohne dass (wie bei herkömmlichen wärmebasierten Fügeverfahren wie Löten oder Sintern) Sorge getragen werden muss, dass das Gehäuse durch die Erwärmung beschädigt wird. Nach Herstellen der Verbindung wird vorteilhafterweise kein Druck mehr auf die Schaltungselemente ausgeübt.

Dabei spielt es keine Rolle, welcher der Kontakte den Zapfen und welcher der Kontakte den Bereich mit einem porösen oder schaumartigen leitfähigen Material aufweist.

In Ausführungsbeispielen wird die Kontaktierung durch mehrere Zapfen bewirkt, die in einen Bereich mit einem porösen oder schaumartigen leitfähigen Material des Partnerkontakts eingebracht werden. Dabei muss es sich nicht um einen einheitlichen Bereich handeln. Vielmehr kann der Partnerkontakt auch mehrere getrennte Bereiche mit porösem oder schaumartigem leitfähigen Material aufweisen, die die Mehrzahl der Zapfen aufnehmen. In besonderen Fällen kann dabei je Zapfen ein strukturell abgegrenzter, vorzugsweise zum Zapfen passend dimensionierter Bereich am Partnerkontakt vorgesehen sein. Im Falle mehrerer Zapfen kann zudem vorgesehen sein, dass diese im Wesentlichen zeitgleich mit dem/den das poröse oder schaumartige leitfähige Material aufweisenden Bereich/en gefügt werden.

Die Zapfen können in einem Raster angeordnet sein, vorzugsweise in einem quadratischen Raster.

Das poröse das poröse oder schaumartige leitfähige Material kann nach Einbringen des Zapfens verdichtet werden, beispielsweise um die Leitfähigkeit und/oder die Stromtragefähigkeit der Verbindung zu erhöhen.

Dabei kann die Verdichtung mittels Pressung und/oder Laserbearbeitung und/oder Wärmebehandlung und/oder mittels Ultraschall bewirkt werden.

Bei den Zapfen kann es sich dabei um Zapfen handeln, die nicht nur für die hier detailliert beschriebene Fügung mit einem porösen oder schaumartigen Material ausgebildet sind, sondern gleichzeitig ausgebildet sind, fallweise mit Partnerkontakten verbunden zu werden, welche zu den Zapfen passende Aussparungen aufweisen, wobei die Zapfen mit den Aussparungen kaltgeschweißte Verbindungen eingehen. Diese Aufbau- und Verbindungstechnik ist in der taggleich mit der vorliegenden Anmeldung eingereichten europäischen Patentanmeldung der gleichen Anmelderin im dem Titel "Auf einen Schaltungsträger aufbringbares Schaltungselement, elektrischer Verbinder sowie Verfahren zum Herstellen einer elektrischen Verbindung" detailliert beschrieben. Zudem ist es auch möglich, einen oder mehrere Zapfen mittels Kaltverschweißung oder Verpressung in Aussparungen des Partnerkontakts, insbesondere in solchen der in der genannten parallelen Anmeldung offenbarten Art, mit dem Partnerkontakt elektrisch leitend zu verbinden und einen oder mehrere Zapfen mittels Fügung mit einem Bereich mit einem porösen oder schaumartigen Material gemäß der vorliegenden Erfindung zu verbinden. Insbesondere kann/können dabei ein, zwei oder mehrere Fügepaare umfassend jeweils einen Zapfen und eine Aussparung beispielsweise zur Präzisionsausrichtung der Fügepartner zueinander verwendet werden und zudem als Teil der elektrischen Kontaktierung dienen, während andere Zapfen mit dem Bereich mit dem porösen oder schaumartigen Material kontaktiert und auf diese Weise unnötige mechanische Beanspruchungen oder sogar Fehlkontaktierungen zu vermieden werden, die beispielsweise aufgrund von Fertigungstoleranzen auftreten können, wenn eine Mehrzahl von Zapfen mit einer Mehrzahl von Aussparungen gefügt werden.

Anders ausgedrückt ist es möglich, die hier beschriebene Erfindung einschließlich aller hier beschriebenen Ausführungsbeispiele mit der in der vorstehend näher bezeichneten parallelen Anmeldung beschriebenen Erfindung einschließlich aller dort beschriebenen Ausführungsbeispiele zu kombinieren. Zur Vermeidung von Wiederholungen wird die parallele Anmeldung in vollem Umfang hier durch Verweis mit einbezogen.

Im folgenden werden Ausführungsbeispiele der vorliegenden Erfindung anhand von Zeichnungen näher erläutert. Es sei darauf hingewiesen, dass sämtliche vorstehend und nachfolgend offenbarten Varianten, Ausgestaltungen und Ausführungsbeispiele uneingeschränkt miteinander kombinierbar sind, und zwar sowohl hinsichtlich der Kontakte des Schaltungselements, des elektrischen Verbinders, als auch des Verfahrens.

Es zeigen:
Fig. 1A in schematischer Darstellung ein Kontaktierung zwischen Zapfen und einem Bereich mit einem porösen oder schaumartigen Material gemäß eines Ausführungsbeispiels der vorliegenden Erfindung;
Fig. 1B die Kontaktierung aus Fig. 1A nach Verdichtung des porösen oder schaumartigen Materials; und
Fig. 2A-C drei verschiedene Ausführungsbeispiele für den Aufbau eines Bereichs mit einem porösen oder schaumartigen Material in stark schematisierter Darstellung.

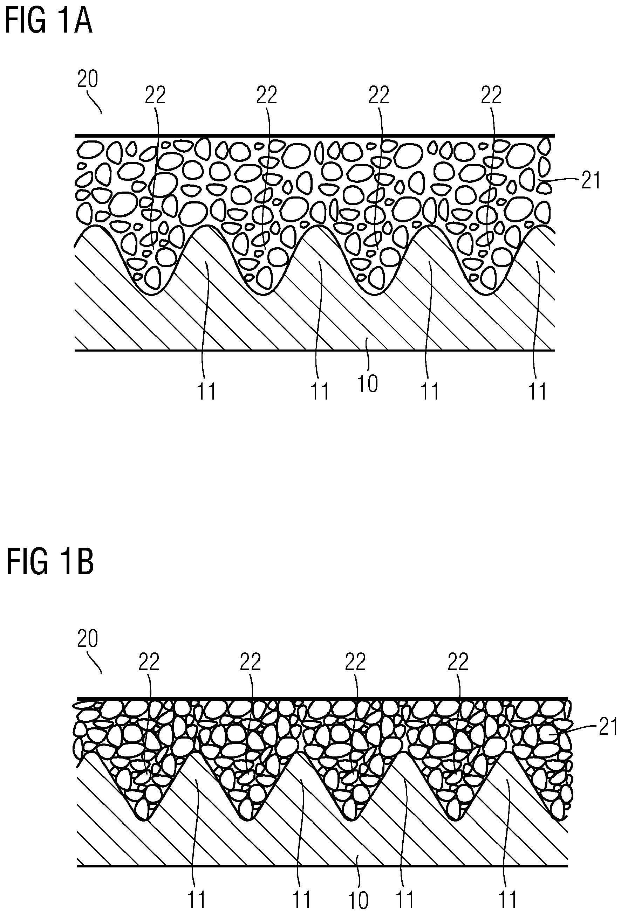

Fig. 1A zeigt in schematischer Schnittdarstellung eine bereits nach dem erfindungsgemäßen Verfahren gefügte elektrische Verbindung zwischen einem ersten Kontakt 10 und einem zweiten Kontakt 20. Der erste Kontakt 10 weist dabei mehrere Zapfen oder sich in die Bildebene hinein erstreckende Zapfenreihen 11 auf, die auf einer im wesentlichen flächigen Kontaktierungsseite des Kontakts 10 ausgebildet sind. Die Zapfen oder Zapfenreihen 11 sind dabei vorzugsweise in regelmäßigen Abständen und besonders vorzugsweise in einem quadratischen Raster angeordnet.

Der zweite Kontakt 20 weist einen Bereich 21 mit einem porösen oder schaumartigen, oder allgemeiner ausgedrückt, einem gegenüber den Zapfen weichen, elektrisch leitfähigen Material auf, in das die Zapfen 11 bereits vollständig eingeführt sind. Das Material im Bereich 21 wird während des Einführens der Zapfen teilweise verdrängt, insbesondere in den die Zapfen 11 umschließenden Teilbereichen 22 des Bereichs 21, und dabei auch jedenfalls teilweise verdichtet. Umgekehrt kann in Ausführungsbeispielen auch eine zumindest leichte, gewollte Verformung der Zapfen 11 während des Einführens in den Bereich 21 stattfinden. So können beispielsweise Zapfen mit einem Kern aus einem härteren Material mit einem weich(er)en Material umkleidet werden, um die wechselseitige Verformung während des Einführvorgangs zu befördern und eine bessere Kontaktierung zu erreichen.

Die Zapfen 11 sind im Beispiel der Fig. 1A im Wesentlichen kreiskegelförmig, können aber natürlich auch andere geeignete Formen annehmen, beispielsweise zylindrisch mit kreisförmigem Querschnitt. Es kommen aber auch andere Querschnitte wie Ellipsen, Dreiecke, Vierecke, insbesondere Quadrate usw. in Betracht, die auch komplexere Formen annehmen können, die also beispielsweise (wenn seitlich betrachtet) Verjüngungen, Hinterschnitte oder Verbindungen zueinander aufweisen können. Auch ist es möglich, die Zapfen säulenförmig bzw. pillarförmig auszugestalten, d.h. mit einem im Vergleich zur Länge kleinen Durchmesser, beispielsweise mit einer Länge von 2,0 mm und einem Durchmesser von 0,5 mm. In anderen Ausgestaltungen ist es möglich, sich verjüngende Zapfen zu wählen, wie in Fig. 1A angedeutet.

Anzahl, Form und Dimension der Zapfen kann je nach Anwendung und der für Zapfen und das leitfähige Material des Partnerkontakts gewählten Herstellungstechnologie in einem breiten Rahmen frei gewählt werden. So ist es möglich, beispielsweise bei nur geringer elektrischer oder thermischer Belastung, wenige Zapfen oder auch nur einen Zapfen vorzusehen. In anderen Anwendungen ist es hingegen sinnvoll, eine Vielzahl von Zapfen zu verwenden, beispielsweise um die gesamte Kontaktierungsfläche, die mit der Zahl der Zapfen bzw. Pillars steigt, zu erhöhen.

Die Zapfen können durch verschiedene Verfahren hergestellt werden. Beispielsweise kommen Verfahren in Betracht, bei denen in einem Verfahrensgang der jeweiligen Kontakt 10 mit den Zapfen 11 erzeugt wird, also beispielsweise Präge- oder Druckgussverfahren, aber auch die im folgenden beschriebenen Verfahren, die sich besonders zum Herstellen von Zapfen oder Pillars direkt auf einem Halbleiterbauelement eignen.

Insbesondere dort bieten sich additive Fertigungsverfahren an, aber auch galvanische Fertigungsverfahren sowie thermische Sprühverfahren und/oder Sinterverfahren, insbesondere mit Silber. Der Begriff "thermische Sprühverfahren" wird hier als Oberbegriff u.a. für folgende Verfahren verwendet: Aufbringen von Material durch Zerstäuben aus einer Schmelze (Schmelzbadspritzen), Aufbringen von Material durch elektrische Lichtbogen- oder Gasentladung (z.B. Lichtbogenspritzen oder Plasmaspritzen), Aufbringen von Material durch Gasexpansion ohne Verbrennung (z.B. Kaltgasspritzen), Aufbringen von Material mit Hilfe von Verbrennungsprozessen (z.B. Drahtflammspritzen, Pulverflammspritzen, Hochgeschwindigkeitsflammspritzen, Detonationsspritzen) oder Aufbringen von Material mit Hilfe gebündelter energetischer Strahlen (z.B. Laserspritzen) .

Als Material für die Zapfen bzw. Pillars kommen insbesondere Cu, Ag, Au, Fe, Sn, Ni, Al, Mo, Wo bzw. Legierungen aus mindestens einem dieser Elemente in Betracht. Aber auch Halbmetalle, Metall-Keramiken, hochdotierte Halbleiter wie beispielsweise Si, SiC, GaN oder graphitbasierte Materialien können verwendet werden. Die Zapfen bzw. Pillars können auch aus verschiedenen Materialkombinationen aufgebaut sein, wie z.B. Kupfer an einem Ende des Pillars und Graphit am anderen Ende.

Um einen effizienten elektrischen Kontakt zwischen Zapfen und weichem Material zu gewährleisten, können die Zapfen mit einem metallischen Material oder Lot überzogen sein, beispielsweise mit Sn, Au, Ag. Hierdurch kann beispielsweise durch eine oxidfreie Oberfläche (Au) und/oder durch ein "Verschmieren" eines weichen Metalls (Sn) auf dem Zapfen eine Verbindung hoher Qualität mit dem weichen Material 21 erleichtert werden.

Der Bereich 21 ist im in Fig. 1 dargestellten Beispiel als einheitlich dargestellt. In anderen Ausführungsbeispielen ist es jedoch ohne weiteres möglich, den zur Aufnahme der Zapfen vorgesehenen Bereich in Teilbereiche oder Verbindungsinseln aufzuteilen, die aneinandergrenzen oder durch Bereiche ohne weiches Material getrennt werden können. Es ist auch möglich, diese Teilbereiche mit verschiedenem weichen Material auszustatten, um die Kontaktgüte über einen weiten Temperaturbereich sicherzustellen, beispielsweise indem in einem ersten Teilbereich ein weiches Material mit einer guten Leitfähigkeit in einem ersten, unteren Temperaturbereich gewählt wird und in einem zweiten Teilbereich ein anderes weiches Material mit einer guten Leitfähigkeit in einem zweiten, über dem ersten Temperaturbereich liegenden Temperaturbereich gewählt wird.

Die Kontakte 10, 20 können auf bzw. an beliebigen Schaltungselementen, Verbindern sowie dem Schaltungsträger selbst angeordnet bzw. integral damit ausgebildet sein (nicht dargestellt). Beim Schaltungsträger kann es sich um ein herkömmliches Printed Circuit Board (PCB) handeln, ein Active Metal Braze Substrat (AMB) oder um einen Direct Copper Bond (DCB) Träger, um einen oder mehrere Leadframes oder um ein organische Dick-Kupfer-Polymer-Substrat. Mit Dick-Kupfer-Substrat sind dabei Kupferdicken von mehr als 0,3 mm gemeint, also beispielsweise 1,0 mm, 2,0 mm oder 4,0 mm.

Beim Schaltungselement kann es sich um ein aktives oder passives Schaltungselement handeln, insbesondere um einen Leistungshalbleiter. Das Schaltungselement kann trägerseitig mit dem hier beschriebenen Verfahren auf dem Träger aufgebracht sein oder mit einem herkömmlichen Verfahren, beispielsweise durch Auflöten oder durch Sinterverfahren oder durch das in der weiter oben genauer bezeichneten parallelen Patentanmeldung offenbarte Verfahren. Ein Schaltungselement kann dabei einseitig oder auf mehreren Seiten Kontakte der hier beschriebenen Art aufweisen. Dabei kann das Schaltungselement sowohl nur Kontakte mit Zapfen als auch nur Kontakte mit weichen Bereichen als auch eine Kombination beider Kontaktformen aufweisen.

Für bestimmte Anwendungen und bestimmte Materialkombinationen zwischen Zapfenmaterial und weichem Material ist die nach Fügen mit einer nur geringen Fügekraft erreichbare Kontaktierung bereits ausreichend, sowohl für die elektrische Leitfähigkeit der Kontaktierung als auch für die thermische Leitfähigkeit der Kontaktierung, soweit es auf die thermische Leitfähigkeit der Kontaktierung im jeweiligen Anwendungsfall überhaupt ankommt.

In anderen Ausführungsbeispielen ist es vorteilhaft, das weiche Material 21 nach dem Fügen weiter zu verdichten. Das Ergebnis der Verdichtung ist in Fig. 1B in schematischer Schnittdarstellung gezeigt. Die Verdichtung kann durch verschiedene Maßnahmen erreicht werden. Insbesondere kommen infrage: die Ausübung einer über die Fügekraft, mit der der in Fig. 1A dargestellte Zustand erreicht wird, hinausgehenden Verdichtungskraft; Laserbearbeitungen; Wärmebehandlung, vorzugsweise bei Temperaturen, die niedriger sind als die beim Löten auftretenden Temperaturen; Zuführung von Energie mittels Ultraschall; sowie geeignete Kombinationen dieser Maßnahmen, also beispielsweise Erwärmen der Fügestelle vor dem Ausüben einer Verdichtungskraft.

Im Ergebnis ist der gesamte Bereich 21 und insbesondere die die Zapfen 11 umschließenden Teilbereichen 22 verdichtet, wodurch beispielsweise die elektrische Leitfähigkeit des weichen Materials und/oder seine Temperaturbeständigkeit verbessert werden können.

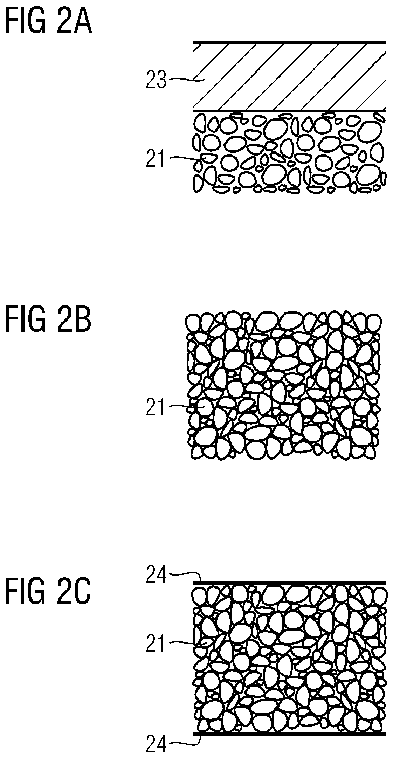

In besonderen Ausführungsbeispielen kann durch geeignete Gestaltung der Zapfen 11 und des Kontakts 20 und insbesondere des mit bezüglich des Zapfenmaterials weichem Material ausgestatteten Bereichs 21 erreicht werden, dass die Zapfen 11 nach Verdichtung des weichen Materials 21 in direktem mechanischen und elektrischen Kontakt mit einer härteren Basisschicht (siehe hierzu Fig. 2) des Kontakts 20 stehen, um beispielsweise die elektrische Leitfähigkeit und Zuverlässigkeit der Kontaktierung weiter zu erhöhen. Insbesondere in diesem Fall kann es sich anbieten, die Zapfen jedenfalls an ihrem oberen Ende mit einem weicheren Material auszustatten, so dass die Zapfen ihrerseits durch Verformung an der Basis des Kontakts eine bessere (sekundäre) Kontaktierung ermöglichen.

In Fig. 2 sind drei verschiedene Varianten für den Aufbau eines Kontakts 20 zur Aufnahme von Zapfen 11 in stark schematisierter Darstellung gezeigt.

Im Beispiel der Fig. 2A ist das poröse oder schaumartige, oder allgemeiner ausgedrückt, das gegenüber den Zapfen weiche, elektrisch leitfähige Material 21 des Kontakts 20 auf einem demgegenüber härteren, flächigen Träger 23, beispielsweise einem Blech 23, aufgebracht. In Ausführungsbeispielen kann ein allmählicher Übergang zwischen dem Träger und dem porösen Material gestaltet werden. In anderen Ausführungsbeispielen sind der Träger und das weiche Material von einander weitgehend übergangsfrei abgegrenzt. Bei dem in Fig. 2A dargestellten Kontakt erfolgt die Fügung mit den Zapfen von unten her, d.h. auf der Seite des Kontakts, welche das weiche Material 21 aufweist.

Im Beispiel der Fig. 2B besteht der Kontakt 20 im Wesentlichen aus dem porösen oder schaumartigen bzw. gegenüber dem Zapfen weichen, elektrisch leitfähigen Material 21, d.h. das weiche Material 21 wird so gewählt, dass es ohne gesonderten Träger einen mechanisch stabilen Kontakt 20 bildet, aber dennoch gegenüber dem Zapfenmaterial weich genug ist, um (ggf. unter Anwendung eines die Form des Kontakts 20 sichernden Werkzeugs) das Eindringen der Zapfen zu ermöglichen, ohne dass sich der Kontakt 20 zur Unbrauchbarkeit verformt. Insbesondere in diesem Beispiel bietet es sich an, das weiche Material 21 nach Fügen mit den Zapfen 11 zu verdichten, wie im Zusammenhang mit Fig. 1B bereits erläutert. Vorteilhaft hat der in Fig. 2B dargestellte Kontakt keine Vorzugs-Montagerichtung, kann also von jeder Seite her und auch unter beliebigen Winkeln mit den Zapfen gefügt werden, solange nicht die übergeordnete Befestigung des Kontaktes am jeweiligen Bauelement (nicht dargestellt) ein Hindernis bildet.

Im Beispiel der Fig. 2C ist eine Sandwichbauform für einen Kontakt 20 gezeigt, bei der das poröse oder schaumartige bzw. gegenüber den Zapfen weiche, elektrisch leitfähige Material 21 des Kontakts 20 zwischen zwei flächigen Trägern 24 eingebettet ist, die aus einem gegenüber dem weichen Material härteren Material bestehen und bei denen es sich beispielsweise um Bleche handeln kann. Die Stärke der Bleche 24 kann dabei annähernd gleich sein, oder für eines der Bleche wird eine größere Stärke und/oder ein härteres Material gewählt als für das andere Blech. Dieses widerstandsfähigere Blech bildet dann den Träger des Kontakts, während das andere Blech das weiche Material 21 stabilisiert und schützt. In diesem Fall erfolgt die Fügung mit den Zapfen auf der Seite des Kontakts, welche das weniger widerstandsfähige Blech 24 aufweist, wobei die Zapfen geeignet geformt sind, um das weniger widerstandsfähige Blech während des Fügevorgangs zu durchstoßen oder wobei vor der Fügung mit den Zapfen entsprechende Löcher in das weniger widerstandsfähige Blech eingebracht werden.

In anderen Ausgestaltungen der in Fig. 2C dargestellten Variante sind die beiden Bleche 24 von annähernd gleicher Widerstandsfähigkeit und zusammen mit dem weichen Material 21 so gewählt, dass die Kombination aus Sandwichblechen 24 und weichem Material 21, welches die Bleche 24 zusammenhält, die gewünschten mechanischen Eigenschaften des Kontakts 20 sicherstellt. In diesen Ausgestaltungen kann die Fügung mit den Zapfen aus zwei Richtungen, nämlich vorzugsweise senkrecht zu den von den Blechen 24 aufgespannten Ebenen, erfolgen, in der Darstellung der Fig. 2C also von oben und von unten. Es sei darauf hingewiesen, dass auch Kontaktformen denkbar sind, bei denen gebogene Bleche das weiche Material zumindest teilweise umschließen, und/oder Kontakte, bei denen mehrere, vorzugsweise vier Bleche das weiche Material in Längsrichtung (d.h. von links nach rechts in der Darstellung der Fig. 2C) vollständig umschließen, wodurch sich dann entsprechend weitere Kontaktierungsrichtungen ergeben. "Sandwichform" ist mit anderen Worten hier als beschränkt auf zwei im wesentlichen parallele Bleche 24 zu verstehen.

In allen drei in Fig. 2 gezeigten Ausgestaltungen wird das weiche Material 21 und ggf. die Bleche 23, 24 so gewählt, dass die gewünschten mechanischen Eigenschaften des Kontakts 20 sicherstellt sind. Beispielsweise kann der Kontakt 20 als aus dem Bauelement herausragende Kontaktfahne ausgebildet sein, mit entsprechenden Anforderungen an Flexibilität bei gleichzeitiger mechanischer Festigkeit. In anderen Anwendungen kann der Kontakt 20 flächig an einer Fläche des Bauelements angeordnet sein und wird durch diese Fläche bzw. das Bauelement selbst mechanisch stabilisiert.

Für das weiche Material eignen sich besonders duktile und gut leitfähige reine Metall wie Kupfer, Silber, Aluminium, Nickel oder Zinn. Je nach Ausführung kann das weiche Material wie in Fig. 2B dargestellt ohne weitere Schichten oder wie in Fig. 2A und 2C dargestellt mit begrenzenden Außenschichten 23, 24 zum Einsatz kommen,

Bei Bauteilen, bei denen die Kontakte viel Wärme ableiten und/oder hohe Ströme transportieren sollen, kann eine Schicht 23, 24 als Trägermaterial fungieren und bevorzugt aus Kupfer bestehen. Es dient der mechanischen Stabilität und zusätzlichen Vergrößerung des Leiterquerschnitts.

Bei der Gestaltung als Sandwich gemäß Fig. 2C kann insbesondere die Seite, die für das Fügen mit dem/den Zapfen vorgesehen ist, dünner ausgeführt werden als eine Seite, die für das Fügen nicht vorgesehen ist. Diese Fügeseite kann insbesondere sehr dünn in Art einer Haut ausgebildet sein und vorzugweise aus dem gleichen Material bestehen wie das weiche Material.

Es sind mit anderen Worten auch asymmetrische Sandwich-Ausführungen möglich, beispielsweise indem auf einem flächigen Träger aus Kupfer ein weiches poröses oder schaumartiges Metall aufgebracht ist, das auf der Fügeseite eine flächige Außenhaut, d.h. eine dünne Schicht, aufweist, die beispielsweise während des Herstellungsprozesses entsteht und anschließend nicht entfernt wird oder die in einem zusätzlichen Herstellungsschritt aufgetragen wird.

Es sei darauf hingewiesen, dass die Ausführungsbeispiele der vorliegenden Erfindung auf Leistungshalbleiter Bezug nehmen, weil dort die zuverlässige, möglichst großflächige, möglichst chipnahe und deswegen möglichst ohne Zuführung von Wärme durchgeführte Kontaktierung von besonderer Bedeutung ist. Die Erfindung ist aber natürlich nicht auf Leistungshalbleiter beschränkt, sondern im Zusammenhang mit allen auf Schaltungsträgern montierbaren Bauelementen, aktiv oder passiv, einsetzbar.

## Patentansprüche

1. Elektrischer Kontakt (10) eines auf einen Schaltungsträger aufbringbaren Schaltungselements oder eines elektrischen Verbinders, wobei der Kontakt (10) einen flächigen Abschnitt aufweist, auf dem ein Zapfen (11) ausgebildet ist, der zum Einbringen in einen ein poröses oder schaumartiges leitfähiges Material aufweisenden Bereich (21) eines elektrischen Kontakts (20) eines anderen Elements ausgebildet ist und im gefügten Zustand mit diesem Bereich eine elektrisch leitende Verbindung bildet.

2. Elektrischer Kontakt (10) nach Anspruch 1, dessen flächiger Abschnitt mehrere Zapfen (11) aufweist.

3. Elektrischer Kontakt (10) nach Anspruch 2, bei dem die Zapfen in einem Raster angeordnet sind, vorzugsweise in einem quadratischen Raster.

4. Elektrischer Kontakt (20) eines auf einen Schaltungsträger aufbringbaren Schaltungselements oder eines elektrischen Verbinders, wobei der Kontakt einen flächigen Abschnitt aufweist, auf dem ein ein poröses oder schaumartiges leitfähiges Material aufweisender Bereich (21) ausgebildet ist, welcher zur Aufnahme eines oder mehrerer Zapfen (11) eines elektrischen Kontakts (10) eines anderen Elements ausgebildet ist, wobei dieser Bereich im gefügten Zustand mit dem oder den Zapfen eine elektrisch leitende Verbindung bildet.

5. Element einer auf einem Schaltungsträger aufbringbaren Schaltung mit einem oder mehreren Kontakten (10) nach einem der Ansprüche 1 bis 3 und/oder mit einem oder mehreren Kontakten (20) nach Anspruch 4 und/oder mit einem oder mehreren Kontakten, die auf einer Seite gemäß einem der Ansprüche 1 bis 3 und auf der anderen Seite gemäß Anspruch 4 ausgebildet sind.

6. Verfahren zum Herstellen einer elektrisch leitenden Verbindung zwischen einem auf einem Schaltungsträger anbringbaren Schaltungselement und einem weiteren Element, mit folgenden Schritten:
- Bereitstellen jeweils eines elektrischen Kontakts (10, 20) mit einem flächigen Abschnitt an dem Schaltungselement und an dem weiteren Element;
- Bereitstellen eines Zapfens (11) aus leitfähigem Material auf dem flächigen Abschnitt eines der Kontakte (10) sowie Bereitstellen eines ein poröses oder schaumartiges leitfähiges Material aufweisenden Bereichs (21) auf dem flächigen Abschnitt des anderen Kontaktes (20); und
- Einbringen des Zapfens (11) in den Bereich (21) und dabei teilweises Verdrängen des porösen oder schaumartigen leitfähigen Materials (21) durch den Zapfen (11) und somit Bewirken einer elektrisch leitenden Verbindung.

7. Verfahren nach Anspruch 6, bei dem das poröse oder schaumartige leitfähige Material (21) während und/oder nach Einbringen des Zapfens verdichtet wird.

8. Verfahren nach Anspruch 7, bei dem die Verdichtung des Materials mittels Pressung und/oder Laserbearbeitung und/oder Wärmebehandlung und/oder mittels Ultraschall bewirkt wird.

9. Verfahren nach einem der Ansprüche 6 bis 8, bei dem mehrere Zapfen (11) bereitgestellt und im Wesentlichen gleichzeitig mit dem das poröse oder schaumartige leitfähige Material aufweisenden Bereich (21) gefügt werden.
